# EUROPÄISCHE PATENTANMELDUNG

(11) **EP 0 579 048 A2**
(43) Veröffentlichungstag der Anmeldung: **19.01.1994**
(21) Anmeldenummer: 93110514.2
(22) Anmeldetag: 01.07.1993
(51) Int. Cl.: H01L 41/00

(54) **Bei niedrigen Temperaturen sinterbarer Versatz zur Herstellung von piezoelektrischen, keramischen Formkörpern und daraus durch Sintern hergestellte Formkörper**

(30) Priorität: 15.07.1992 DE 4223186
(71) Anmelder: Hoechst CeramTec Aktiengesellschaft, D-95100 Selb (DE)
(72) Erfinder: Helke, Günter, Dr., D-8560 Lauf (DE); Langer, Hans-Joachim, D-8560 Lauf (DE); Handschuh, Kurt, D-8501 Eckental (DE)
(74) Vertreter: Hoffmann, Peter, Dipl.-Chem.

(57) **Zusammenfassung**

Die Erfindung betrifft einen bei niedrigen Temperaturen sinterbaren Versatz auf Basis von Bleititanatzirkonat zur Herstellung von piezoelektrischen, keramischen Formkörpern. Der Versatz enthält als Modifikator eine komplexe bleifreie Perowskirverbindung mit der allgemeinen Formel:

A²⁺(B³⁺ B⁵⁺)O₃,

in der die Symbole:
- A²⁺: die Elemente Calzium oder Strontium,
- B³⁺: das Element Wismut und
- B⁵⁺: die Elemente Antimon, Niob oder Tantal versinnbildlichen.

Die Erfindung betrifft auch ein Verfahren zum Versintern des Versatzes sowie durch Versintern hergestellte piezoelektrische Formteile.

## Beschreibung

Bei niedrigen Temperaturen sinterbarer Versatz zur Herstellung Von piezoelektrischen, keramischen Formkörpern und daraus durch Sintern hergestellte Formkörper
Die vorliegende Erfindung betrifft einen bei niedrigen Temperaturen sinterbaren Versatz zur Herstellung von piezoelektrischen, keramischen Formkörpern, die eine hohe Dielektrizitätszahl und eine niedrige mechanische Güte aufweisen und die sich besonders für Vielschichtmonolithe für elektromechanische Aktuatoren eignen, insbesondere durch Versinterung bei niedrigen Temperaturen zusammen mit kostengünstigen Elektrodenmetallen zu Verbundmaterialien.

Es sind bereits vielfältige Möglichkeiten bekannt, wie Zusammensetzungen auf der Basis von festen Lösungen von Bleititanatzirkonat Pb(Ti,Zr)O₃, von Bleititanat PbTi0₃ und von Bleizirkonat PbZr0₃ durch Zusätze und/oder Substitute so modifiziert werden können, daß anwendungsgerechte Spezifikationen von piezokeramischen Werkstoffen daraus resultieren.

Bekannt sind insbesondere Variationen der Eigenschaften in Abhängigkeit von dem stöchiometrischen Verhältnis von Titan zu Zirkonium im Pb(Ti,Zr)0₃, der Einflüsse einer teilweisen Substitution von Erdalkalimetallen wie Ca und Sr anstelle von Pb, die Wirkung beispielsweise von Zusätzen drei- und fünfwertiger Ionen der Elemente wie Bi, La, Sb, Nb, Ta als Dotiermittel oder die Bildung von festen Lösungen des Bleititanatzirkonat mit komplexen Verbindungen, die ebenso wie das Bleititanatzirkonat die Kristallstruktur des Perowskits mit der Formel A²⁺B⁴⁺O₃²⁻ besitzen.

Die allgemeine Formel beliebig modifizierter Zusammensetzungen auf der Basis von Pb(Ti,Zr)0₃ ist dann:

(A₁, A₂..Aₙ) (B₁, B₂...Bₙ) O₃

.

Stöchiometrie und Ladungsneutralität werden durch die Einhaltung von Existenzbedingungen für komplexe Verbindungen wie

Pb(B²⁺_{1/3} B⁵⁺_{2/3})O₃, Pb(B³⁺_{1/2} B⁵⁺_{1/2})O₃

,

Pb(B²⁺_{1/2} B⁶⁺_{1/2})0₃, Pb(B³⁺_{2/3} B⁶⁺_{1/3})O₃, Pb(B¹⁺_{1/4} B⁵⁺_{3/4})O₃

gewährleistet.

Durch die Vielzahl von Modifikationen des Pb(Ti,Zr)O₃ durch Zusätze der oben aufgeführten Bleiperowskite können sehr leistungsfähige piezokeramische Formkörper mit unterschiedlichster Spezifikation und Qualität synthetisiert werden (siehe Jap. J. Electronic Eng. JEE 1979, Febr. PP. 44-47).

Die Sintertemperaturen liegen für die bekannten piezokeramischen Formkörper bei etwa 1.200 bzw. 1.300 °C. Solche Sintertemperaturen erfordern aber in Anbetracht der dabei verstärkt auftretenden Verdampfung von Blei besondere Vorkehrungen beim Sintern von Piezokeramiken auf der Basis der festen Lösungen mit Pb(Ti,Zr)0₃ als Hauptbestandteil. Einerseits muß nämlich die Gefahr der Störung der Stöchiometrie und damit verbunden einer Beeinträchtigung der funktionellen physikalischen Eigenschaften des gesinterten Materials berücksichtigt werden, andererseits ist die Toxizität der Bleidämpfe nicht zu unterschätzen.

Nach der Optimierung der chemischen Zusammensetzung piezoelektrischer Keramikwerkstoffe stellt sich eine Erniedrigung der Sintertemperatur als neue Herausforderung. Mögliche Lösungswege sind die Aufbereitung feindisperser Pulver, beispielsweise nach dem Sol-Gel-Verfahren als Alternative zur konventionellen Mischoxidtechnik (s. lEEE Trans. 25(1990)5, P. 935-987) oder die Feinzerkleinerung und Aktivierung von konventionell aufbereiteten Kalzinaten (s. J. Amer. Ceram. Soc. 73(1990)7, S. 1862-1867).

Die Reaktivität konventionell aufbereiteter Kalzinate kann auch durch Zusatz von Vanadiumpentoxid V₂O₅ (Geramica 35(1989)222, S. 18-20) oder Wismutoxid Bi₂O₃ (J.Amer. Ceram. Soc. 54(1971)2, S. 113-115) zu den stöchiometrischen Zusammensetzungen der festen Lösungen auf der Basis von Bleititanat und Bleizirkonat erfolgen. Dabei werden diese Zusätze in Fremdphasen als Sinterhilfsmittel wirksam. Niedrig sinternde piezokeramische Werkstoffe mit niedriger Dielektrizitätszahl (ε^{T}₃₃/ε₀ < 1200) und hoher mechanischer Güte (Qₘ > 500) sowie niedrigen dielektrischen Verlusten für Ultraschallgeber und hochfrequente elektromechanische Wandler wurden auch durch die Substitution wismuthaltiger Perowskite mit den Elementen Cadmium oder Nickel erhalten.

Für solche piezokeramische Werkstoffe wirkt sich auch sehr günstig ein Zusatz von Zn(Bi_{2/3}Mn_{1/2})O₃ als Modifikator zu festen Lösungen auf der Basis von Bleititanatzirkonat auf die Erniedrigung der Sintertemperatur aus (vgl. lzv. Akad. Nauk SSSR, Neorg. Mater. 7 (1971) S. 996-1000).

Aufgabe der vorliegenden Erfindung war es nunmehr, eine Sintermasse auf Basis von Bleititanat-Bleizirkonat bereitzustellen, die bei niedrigen Temperaturen unterhalb von 1150 °C zu piezokeramischen Formkörpern versintert werden kann, wobei die so erhaltenen Formkörper sich durch hohe Dielektrizitätszahlen (ε^{T}₃₃/ε₀ > 1500), niedrige mechanische Güte (Qₘ < 100) und große piezoelektrische Aktivität (elektromechanischer Kopplungsfaktor Kₚ <0,50) auszeichnen.

Gelöst wird diese Aufgabe durch einen Sinterversatz auf Basis von Bleititanat-Bleizirkonat, dessen Kennzeichenmerkmal darin zu sehen ist, daß als Modifikator eine komplexe bleifreie Perowskitverbindung mit der allgemeinen Formel:

A²⁺(B³⁺ B⁵⁺)O₃

stöchiometrisch in die ternäre feste Lösung eingebaut ist, wobei die Symbole:
- A²⁺: die Elemente Calzium oder Strontium,
- B³⁺: das Element Wismut und
- B⁵⁺: die Elemente Antimon, Niob oder Tantal bedeuten.

In einer bevorzugten Ausgestaltung der Erfindung liegen die Ionen, die durch die Symbole B³⁺ und B⁵⁺ dargestellt sind in äquimolaren Mengen vor. Besonders bevorzugt sind die Ionen Sr²⁺, Bi³⁺ und Sb⁵⁺ in Form der komplexen Verbindung Sr(Bi_{1/2}Sb_{1/2})O₃ stöchiometrisch in die ternäre feste Lösung:

PbTiO₃ - PbZrO₃ - Sr(Bi_{1/2}Sb_{1/2})O₃

eingebaut.

Durch den Einbau der Verbindung Sr(Bi_{1/2}Sb_{1/2})O₃ in den Sinterversatz werden erfindungsgemäß nicht nur die Ladungsneuträlität und die Stöchiometrie der ternären festen Lösungen aufrechterhalten, sondern es ergibt sich überraschend eine hohe Dielektrizitätszahl ε^{T}₃₃/ε₀ von mehr als 1500 in Kombination mit einer großen piezoelektrischen Aktivität bei niedriger mechanischer Güte Qₘ < 100. Besonders überraschend war es, daß sich durch eine Kombination mit Bi³⁺ eine Sintertemperatur von weniger als 1200 °C, vorzugsweise von weniger als 1140 °C, für den erfindungsgemäßen Sinterversatz erzielen läßt.

Erfindungsgemäß ist die Verbindung Sr(Bi_{1/2}Sb_{1/2})O₃ in dem Sinterversatz in einer Menge im Bereich von 0,5 bis 8,0, vorzugsweise von 1,0 bis 5,0 Mol% enthalten, bezogen auf den Gesamtgehalt des Versatzes an keramischem Material.

Überraschend läßt sich der erfindungsgemäße Sinterversatz nach dem üblichen Herstellungsverfahren, der sogenannten Mischoxidtechnik, einfach zubereiten.

Dadurch wird ein zusätzlicher Aufwand für alternative, speziell verbesserte Zubereitungsverfahren erfindungsgemäß vermieden. Aufgrund der erniedrigten Sintertemperatur wird die Entwicklung von Bleidämpfen während des Sintervorganges ganz signifikant verringert, dadurch wird die stöchiometrische Konstanz des Versatzes verbessert und insbesondere eine Beeinträchtigung der Umwelt wirkungsvoll vermieden.

Grünfolien, die unter Verwendung der erfindungsgemäßen Pulver hergestellt wurden, lassen sich überraschend vorteilhaft für Vielschichtmonolithe für elektromechanische Aktuatoren verwenden, da sie auch bei niedrigen Temperaturen zusammen mit kostengünstigen Elektrodenmetallen zu Verbundmaterialien versintert werden können.

Die nachfolgenden Beispiele sollen die Erfindung für den Fachmann noch anschaulicher beschreiben, ohne aber die Erfindung auf die konkret dargestellten Ausführungsformen zu beschränken.

An den fertiggestellten piezoelektrischen Formkörpern wurden die nachfolgenden physikalischen Eigenschaften:
1. Dielektrizitätszahl ε^{T}₃₃/ε₀,
2. Elektromechanischer Kopplungsfaktor der Radialschwingung kₚ und
3. Gütefaktor Qₘ
gemäß DIN IEC 483 gemessen.

### Ausführungsbeispiel:

Nach herkömmlicher Mischoxidtechnik wurde durch Mischen, Kalzinieren und Mahlen ein Versatz aus 98 Gewichtsteilen Pb(Ti_{0,48}Zr_{0,52})O₃ und 2 Gewichtsteilen Sr(Bi_{0,5}Sb_{0,5})O₃ hergestellt. Pulverpreßlinge aus Preßpulvern (Granulat aus kalziniertem und feingemahlenem Pulver) aus dem Versatz wurde über eine Zeit von 60 Minuten bei einer Temperatur von 1125 °C in geschlossenen Kapseln in einem Elektroofen gesintert. An den so erhaltenen Formkörpern (runde Scheiben mit einem Durchmesser von 12 mm und einer Dicke von 1 mm) wurden nach dem Metallisieren mittels Einbrennen einer Silberpaste und Polarisieren bei einer Gleichspannung von 3,5 kV bei 100 °C im Ölbad über eine Zeitdauer von 5 min die nachfolgend angegebenen physikalischen Eigenschaften bestimmt:
Dielektrizitätszahl ε^{T}₃₃/ε₀ = 1830
Elektromechanischer Kopplungsfaktor kₚ = 0,64
Gütefaktor Qₘ = 75

## Patentansprüche

1. Bei niedrigen Temperaturen sinterbarer Versatz auf Basis von Bleititanatzirkonat zur Herstellung von piezoelektrischen, keramischen Formkörpern, dadurch gekennzeichnet, daß er als Modifikator eine komplexe bleifreie Perowskitverbindung mit der allgemeinen Formel:
A²⁺(B³⁺B⁵⁺)O₃
enthält, wobei die Symbole:
A²⁺ die Elemente Calzium oder Strontium,
B³⁺ das Element Wismut und
B⁵⁺ die Elemente Antimon, Niob oder Tantal bedeuten.

2. Versatz nach Anspruch 1, dadurch gekennzeichent, daß die Ionen, die durch die Symbole B³⁺ und B⁵⁺ dargestellt sind, in äquimolaren Mengen vorliegen.

3. Versatz nach Anspruch 1 oder 2, dadurch gekennzeichnet, daß die Ionen Sr²⁺, Bi³⁺ und Sb⁵⁺ in Form der komplexen Verbindung Sr(Bi_{1/2}Sb_{1/2})O₃ stöchiometrisch in die ternäre feste Lösung:
PbTiO₃ - PbZrO₃ - Sr(Bi_{1/2}Sb_{1/2})O₃
eingebaut sind.

4. Versatz nach Anspruch 3, dadurch gekennzeichnet, daß er die Verbindung Sr(Bi_{1/2}Sb_{1/2})O₃ in einer Menge im Bereich von 0,5 bis 8,0, vorzugsweise von 1,0 bis 5,0 Mol%, enthält, bezogen auf den Gesamtgehalt des Versatzes an keramischem Material.

5. Verfahren zum Versintern eines Versatzes nach einem der Ansprüche 1 bis 4, bei dem der Versatz zu einem Formkörper verformt wird, in einen Ofen eingebracht und gesintert wird, dadurch gekennzeichnet, daß der Sinterprozess über eine Zeitdauer von wenigstens 40 Minuten bei einer Temperatur von weniger als 1200 °C durchgeführt wird.

6. Verfahren nach Anspruch 4, dadurch gekennzeichnet, daß die Sintertemperatur auf weniger als 1140 °C eingestellt wird.

7. Gesinterter piezoelektrischer Formkörper hergestellt nach einem Verfahren nach Anspruch 5 oder 6 aus einem Versatz nach einem der Ansprüche 1 bis 4, dadurch gekennzeichnet, daß er die geometrische Form einer runden oder vieleckigen Scheibe, eines Zylinders oder eines Rohres aufweist.

8. Gesinterter piezoelektrischer Formkörper nach Anspruch 7, dadurch gekennzeichnet, daß er die geometrische Form einer runden Scheibe aufweist und daß er eine hohe Dielektrizitätszahl ε^{T}₃₃/ε₀ im Bereich von >1500, einen elektromechanischen Kopplungsfaktor kₚ von > 0,50 und eine niedrige mechanische Güte Qₘ von < 100 besitzt.

9. Verwendung einer Grünfolie hergestellt aus einem Versatz nach einem der Ansprüche 1 bis 4 für Vielschichtmonolithe für elektromechanische Aktuatoren.

10. Verwendung eines Laminates aus Grünfolien hergestellt aus einem Versatz nach einem der Ansprüche 1 bis 4 zur Versinterung bei niedrigen Temperaturen zusammen mit kostengünstigen Metallen als Innenelektrode in piezokeramischen Vielschichtmonolithen.
